Europäisches Patentamt

European Patent Office

Office européen des brevets

(11) Publication number: 0 675 532 A2

# EUROPEAN PATENT APPLICATION

(21) Application number: 95104788.5

(22) Date of filing: 31.03.95

(51) Int. Cl.6: H01L 21/60, H01L 23/498

(30) Priority: 31.03.94 JP 63682/94

(43) Date of publication of application:
04.10.95 Bulletin 95/40

(84) Designated Contracting States:
DE FR GB

(71) Applicant: Du Pont Kabushiki Kaisha
Arco Tower,
8-1 Shimomeguro 1-chome,
Meguro-ku
Tokyo 153 (JP)
Applicant: NGK Insulators Ltd.
434-3 Gotanda,
Shimozue
Komaki City,
Aichi 485 (JP)

(72) Inventor: Fuwa, Toro
356 Chuo, 1-chome
Komaki-shi,
Aichi-ken, 485 (JP)
Inventor: Nakahashi, Mitsuo
10-8 Moriyama, 3-chome,
Moriyama-ku
Nagoya-shi,
Aichi-ken 463 (JP)
Inventor: Kojo, Hiroki
699-1-208 Ohba-cho, Aoba-ku
Yokohama-shi,
Kanagawa, 255 (JP)
Inventor: Nemoto, Kazumasa
4-12-3 Negishi Taito-ku
Tokyo, 110 (JP)

(74) Representative: von Kreisler, Alek,
Dipl.-Chem. et al
Patentanwälte,
von Kreisler-Selting-Werner,
Bahnhofsvorplatz 1 (Deichmannhaus)
D-50667 Köln (DE)

(54) Method for forming solder bump in IC mounting board.

(57) [Objective] To provide a method of forming solder bumps whereby solder bumps of a sufficient amount of solder can be formed even if miniaturized.

[Constitution] The method of forming solder bumps of this invention is a method of forming solder bumps on a board (1) for mounting IC chips on which conductor wiring has been formed, which method is characterized by

forming a photosensitive first solder resist (3) on the surface of the board on which the conductor wiring (2) has been formed,

forming first openings (3a) by photoetching at the sites of the first solder resist (3) where the solder bumps are to be formed,

forming a second solder resist (4) on the first solder resist,

forming second openings (4a) that connect with the first openings by photoetching at the sites of the second solder resist that correspond to the first openings,

filling the first and second openings with solder (5),

carrying out reflow treatment,

and then etching in such a way that at least part of the first solder resist remains.

[Figure 8]

[Detailed Description of the Invention]

[Industrial field of use]

The present invention relates to a method of forming solder bumps.

[Prior art]

With the increasingly higher integration of IC chips, there is a strong demand for miniaturization of the conductor lines and solder bumps of the chip-mounting boards. As a method of forming solder bumps that responds to this demand for miniaturization, the method of forming a dam pattern of solder resist on the mounting board and forming solder bumps by printing solder paste on this dam pattern is already known. By this known method, a photosensitive solder resist is formed on the mounting board, an openings are formed by photoetching at the sites where the solder bumps are to be formed, solder paste is supplied to these openings by printing, and solder bumps are formed via a reflow treatment.

[Problems to be solved by the invention]

The known method of forming solder bumps described above could not fully satisfy the demand of miniaturization because the amount of solder used in connecting a chip was restricted by the volume of the openings formed in the solder resist. That is, as miniaturization proceeded, the area of the openings formed in the resist layer was also miniaturized, so the effective amount of solder used in connecting a chip decreased. As a result, there was the drawback that the reliability of chip connection declined. Moreover, when solder paste was filled in by printing, the area of the openings filled with the solder paste was smaller, so accurate feeding of solder paste to the openings was difficult. Thus, solder paste ended up on the peripheries of the openings, and there was a risk of shorting between solder bumps. Moreover, the residues of flux and solder, etc., occur on the periphery of the solder bumps, and there was a risk that reliability and durability would decline.

Therefore, the objective of this invention is to provide a method of forming solder bumps that eliminates the above drawbacks and by which solder bumps that are more minute and excel in reliability and durability can be formed.

[Means of solving the problems and action]

The method of forming solder bumps of this invention is a method of forming solder bumps on a board for mounting IC chips on which conductor wiring has been formed, which method is characterized by
forming a liquid, photosensitive first solder resist on the surface of the board on which the conductor wiring has been formed,
forming first openings by photoetching at the sites of the first solder resist where the solder bumps are to be formed,
forming a second solder resist on the first solder resist,
forming second openings that connect with the first openings by photoetching at the sites of the second resist layer that correspond to the first openings,
filling the first and second openings with solder,
carrying out reflow treatment,
and then etching in such a way that at least part of the first solder resist remains.

With the miniaturization of conductor wiring, the width of the conductor lines becomes smaller, and the area of the bumps formed on that wiring also becomes smaller. Therefore, the present invention causes the bumps to be formed as high as possible in order to ensure a sufficient amount of solder. In this case, the depth of the openings becomes even deeper due to also forming a second solder resist on the first solder resist and providing openings for supplying solder. As a result, a large amount of solder can be supplied for forming bumps. Moreover, by removing the second solder resist by etching, the contamination can be removed. Also, the height of the solder bumps from the resist surface can be fully ensured, and reliability improves.

The method of forming solder bumps of this invention is a method of forming solder bumps on a board for mounting IC chips on which conductor wiring has been formed, which method is characterized by
coating a liquid first solder resist on the surface of a board on which

conductor wiring has been formed so as to fill the spaces between the conductor lines,

forming a second solder resist on that first solder resist,

forming openings by photoetching at the sites of the first and second solder resists where the solder bumps will be formed,

filling these openings with solder,

carrying out reflow treatment,

and then etching in such a way that at least part of the first solder resist remains.

As the wiring pattern formed on the board is miniaturized, the spaces between the conductor lines has become smaller. Therefore, if a film-like solder resist is placed directly on a board, it is difficult to fill the spaces between the conductor lines with the solder resist material, and bubbles form and shorts occur between the conductor lines. Hence, a liquid solder resist is coated on the board first. The liquid resist penetrates into fine crevices, so the spaces between conductor lines `can be completely filled with resist material. However, there are limitations on how thickly the liquid resist material can be coated, and a thick resist layer cannot be formed. Therefore, in this invention, a thicker film-like solder resist is laminated on the liquid first solder resist as a second solder resist. A solder resist film of the desired thickness can be obtained, so the spaces between conductor lines can be completely insulated, and bumps of the desired amount of solder can be formed.

The method of forming solder bumps of this invention is characterized by

coating a liquid first solder resist on the surface of the board on which conductor wiring has been formed so that it fills the spaces between the conductor lines,

forming a photosensitive second solder resist on the first solder resist,

forming first openings by photoetching at the sites of the second solder resist where the solder bumps are to be formed,

forming a third solder resist on the second solder resist,

forming second openings that connect to the first openings by photoetching at the sites of the third resist that correspond to the first openings,

filling the first and second openings with solder,

carrying out reflow treatment,

and then removing the third solder resist. If the first and second solder resists are made from a resist material that excels in electrical insulating properties and durability, all of the regions of the conductive wiring other than the parts on which the bumps will be formed are in a state coated with electrical insulating material, and the reliability of the mounting board can be further improved.

Also, if the opening area of the first openings is $S_1$ and the opening area of the second openings is $S_2$ and their ratio is established so that $S_2/S_1 > 1$, a larger amount of solder can be supplied for bump formation, and bumps of the desired amount of solder can easily be formed even if the conductor wiring is miniaturized. Moreover, by forming the solder bumps in a zigzag pattern, even if the first openings overlap the conductor lines, the overlapped parts are reliably separated by the thick second solder layer. Also, the solder is in a contracted state due to reflow treatment and the bumps have almost the same cross-sectional area as the cross sectional area of the first openings. Therefore, problems such as shorting with conductor lines adjacent to the bumps do not occur, and bumps of the desired amount of solder can be formed. As a result, even if the wiring pattern is further miniaturized, it is reliably insulated, and bumps of the desired amount of solder can be formed. Solder bumps suitable for even finer conductor lines can easily be formed.

[Examples]

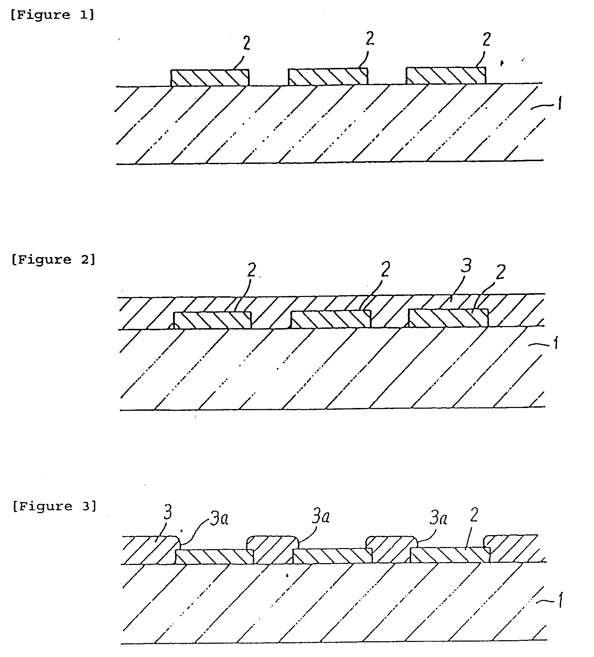

Figures 1-8 are drawings that show a series of processes to explain the method of forming solder bumps of this invention. First, an IC chip mounting board **1** on which the necessary wiring has been formed was made available. This board **1** can be a printed board made of resin material or ceramic material. In the present example, a low-temperature-baked board was used. As shown in Figure 1, a conductor wiring pattern **2** was formed on board **1** by screen printing using copper paste. In this example, the line-width of the conductor line pattern **2** was 100 $\mu$m, and the pitch was 150 $\mu$m. Not only the wiring pattern, but also lands (not shown) for discrete parts were formed on the surface of board **1**.

As shown in Figure 2, the liquid first solder resist **3** was formed on the surface of the board **1** on which the wiring pattern **2** had been formed. This solder resist **3** is a photosensitive solder resist and can be obtained by mixing, for example, a commercially available photosensitive solder resist in a base resin/curing agent ratio of 4:1. The first solder resist **3** was full-surface printed by ordinary screen printing, following which it was dried at 75°C for .25 minutes. The first solder resist was 15 $\mu$m thick.

Next, the first openings were formed by photoetching at the sites of the first solder resist **3** where the solder bumps were to be formed. First, the first solder resist **3** was exposed using a photomask. The exposure conditions were irradiation with a light energy of 800 mJ/cm$^2$ by a 500-W ultrahigh pressure mercury vapor lamp, shielding only the areas where the solder bumps were to be formed, and curing the areas other than this. The solder-bump-forming regions were rectangles of the dimensions 200 × 100 $\mu$m (extending 200 $\mu$m in the line direction). Then spray development was carried out using a 1% aqueous sodium carbonate solution, and the areas of the first solder resist **3** where the solder bumps were to be formed were removed to form the first openings **3a**. The development conditions were development using a spray developing machine at a pressure of 2 kg/cm$^2$ for 60 seconds. Then the board was washed and dried, and the pattern shown in Figure 3 was obtained.

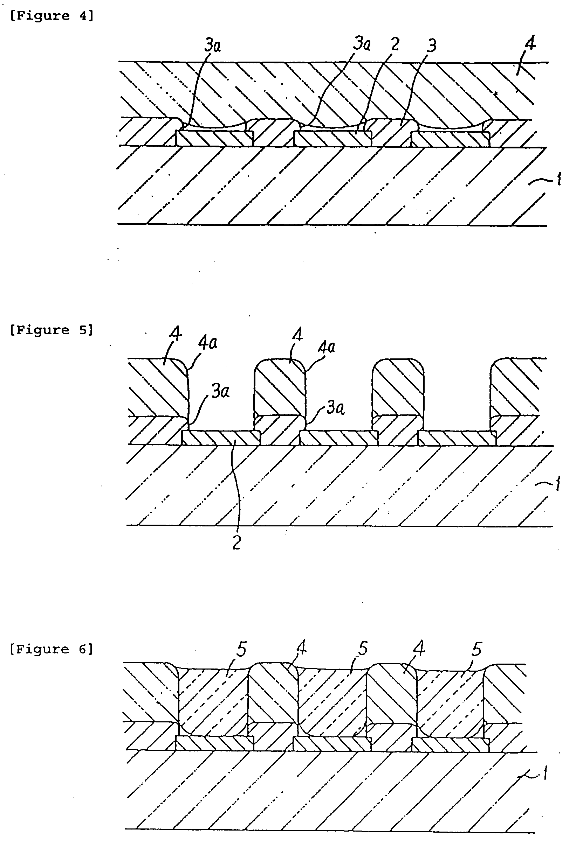

Next, the second solder resist **4** was formed on the board shown in Figure 3 [sic; 4?]. In this example, a 38-$\mu$m thick photosensitive dry film in sheet form was used as the second solder resist. A dry film of the trade name Riston, manufactured by Du Pont, was used as an example of this dry film. This second solder resist **4** was laminated on the first solder resist **3** using a laminator. In this instance, gaps formed in the parts at the first openings **3a**, but these parts were removed later, so they were not a problem. Second openings were formed in this sheet-like second solder resist **4** by photoetching. The photomask used in forming the first openings was used at this time. For exposure, a 500-W ultrahigh pressure mercury vapor lamp was used, and the amount of exposure was 50 mL/cm$^2$. Next, this was spray developed using a 1% aqueous sodium carbonate solution, and second openings **4a** that connected with the first openings **3a** were formed in the solder-bump-forming areas. Through washing and drying processes, the pattern shown in Figure 5 was obtained.

Next, as shown in Figure 6, solder paste was supplied to the first and second openings by printing using a 0.03 mm-thick metal mask. Solder **5** can also be filled in the openings directly with a squeegee without the use of a metal mask.

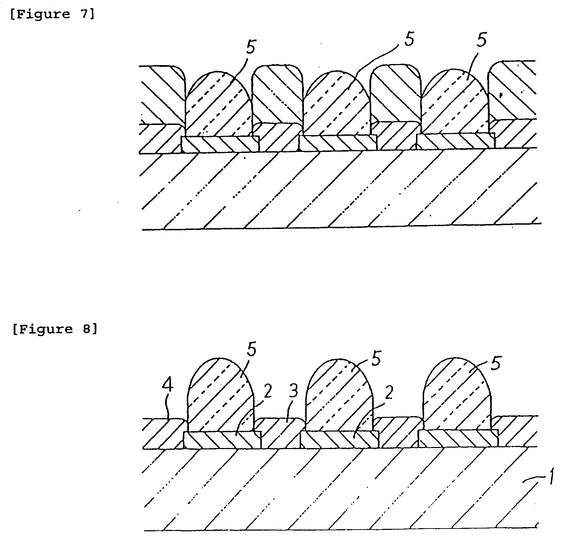

Next, as shown in Figure 7, reflow treatment was carried out on the board by introducing it into a reflow oven set at 230°C.

Afterwards, the substrate was immersed in a 2% aqueous sodium hydroxide solution for 5 minutes to remove only the second solder resist. At this time, etching was performed so that at least part of the first solder resist remained. When a 2% aqueous sodium hydroxide solution is used as the etchant, the etching rate of the dry film is fast, but the etching rate of the first solder resist material is extremely slow, so the solder bumps shown in Figure 8 were obtained in this way. By removing the solder resist **4**, the residues of flux and solder produced during solder coating can be removed, and durability, and reliability can be improved. Also, the amount of solder necessary to connect ICs can be obtained just by appropriately establishing the thicknesses of the first solder resist **3** and second solder resist **4**, especially that of the sheet-like second solder resist.

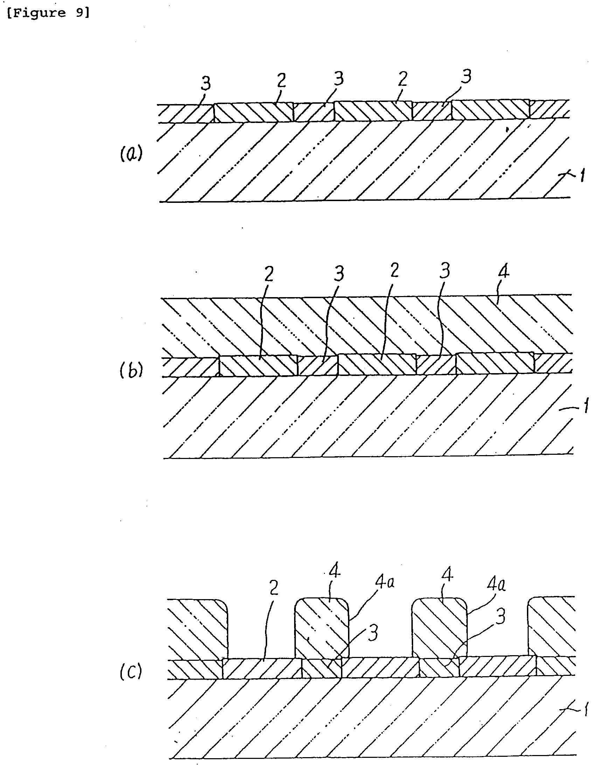

Figure 9 is a diagrammatic cross section that shows a modification of the method of forming solder bumps of this invention. In the example described above, the first solder resist **3** was made relatively thick, but here the first solder resist material was coated so that the liquid solder resist fills the spaces in the wiring pattern **2** as shown in Figure 9(a), the sheet-like second solder resist **4** was laminated on that (Figure 9(b)), and then openings were formed by photoetching as shown in Figure 9(c). In this example, the first solder resist material was filled in the spaces between the lines, the second solder resist **4** was formed over the wiring pattern, and then openings **4a** were formed by photoetching at the sites where the solder bumps were to be formed as shown in Figure 9(c). In this instance, both the first and second solder resist materials can be cured by one exposure process, with the result that one photoetching process can be eliminated. The solder bumps were subsequently formed via a solder supply process and a reflow process. In this example, it is also possible to coat the liquid photosensitive solder resist material so as to fill the spaces between the conductor lines, supply the same resist material by printing to form the first solder resist, form the first openings by photoetching, laminate a dry film, form the second openings, supply solder and carry out reflow treatment, and then remove just the dry film.

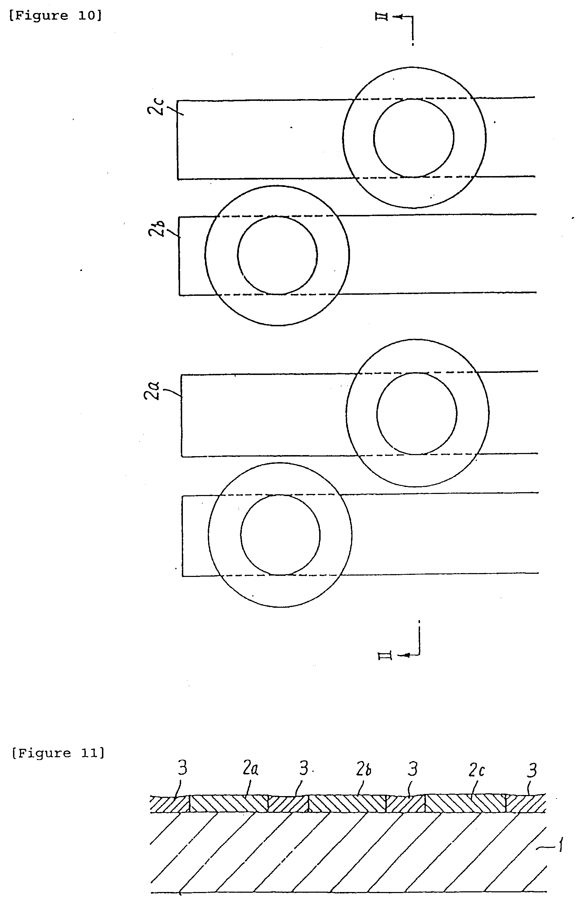

Figures 10 through 18 are diagrammatic cross sections showing another modification of the method of forming solder bumps of this invention. This example explains a method of forming solder bumps that can be further miniaturized. The same structural elements as in the examples described above are explained using the same symbols. Figure 10 is a diagrammatic plan view showing the configuration immediately before filling in the solder. In this example, the solder bumps were formed in a zigzag pattern. Figures 11 through 17 are a series of process drawings in which the board is viewed from line II-II in Figure 10.

As shown in Figure 11, the first solder resist **3** was coated on a board **1** on which conductor lines **2a** through **2c** had been formed, so as to fill the spaces between conductor lines **2a-2c**. In this example, a liquid photosensitive polyimide resin was used as the first solder resist **3**, and this was dried.

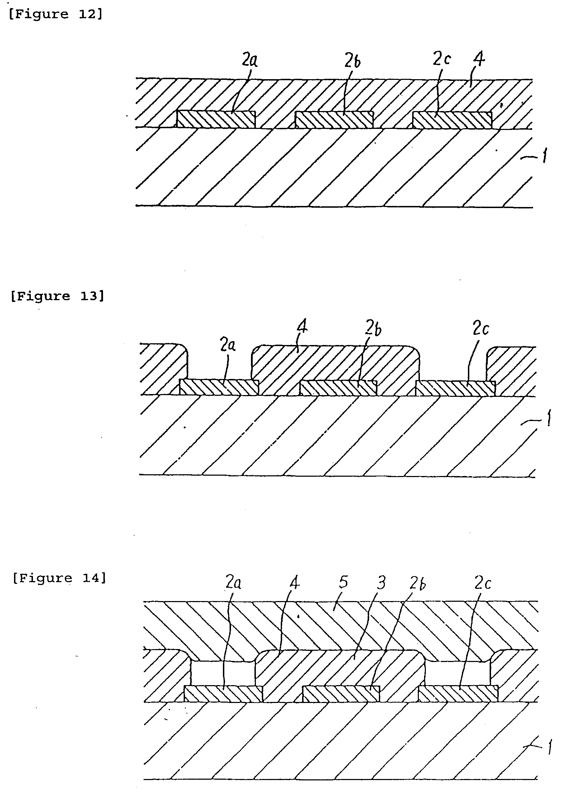

Next, as shown in Figure 12, a polyimide film was laminated on this board as the second solder resist **3**. In this case, the spaces between the conductor lines were filled with polyimide resin, so the problem of bubble formation in the spaces between the conductor lines did not arise.

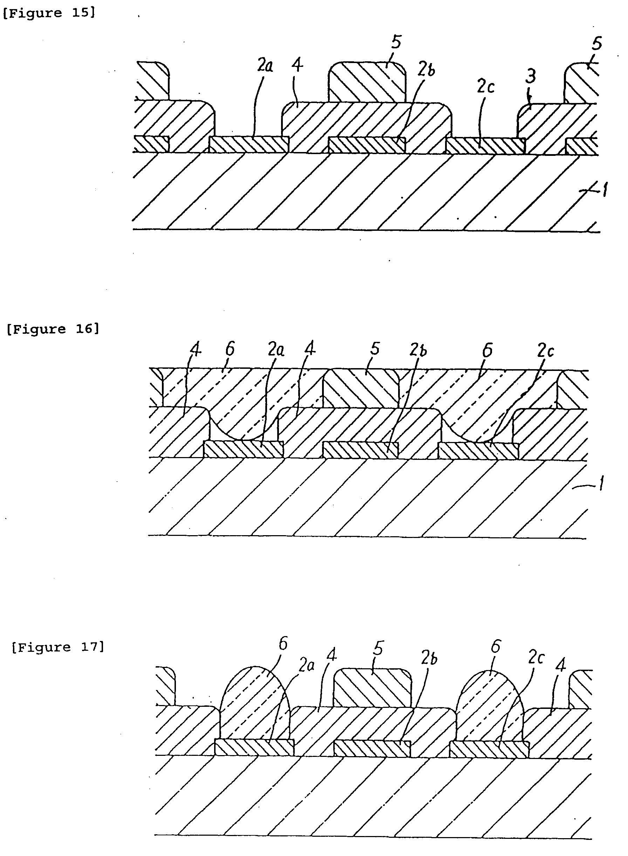

Next, photoetching was carried out. As shown in Figure 13, first openings that were round and had an area of $S_1$ were formed at the sites on the conductor lines where the solder bumps were to be formed. In this example, the solder bumps zigzag in the line direction on the conductor wiring **2b**. A special developer composed mainly of N-methylpyrrolidone (NMP) was used as the developer when etching.

Next, as shown in Figure 14, a dry film was laminated as the third solder resist **10** on the second solder resist **4** in which openings had been formed.

Next, second openings having an opening area of $S_2$ that were round and connected with the first openings were formed by photoetching at the sites where the solder bumps were to be formed. In this instance, a 1% aqueous sodium carbonate solution was used as the developer. This 1% aqueous sodium carbonate solution had a high etching effect on the dry film **10**, but hardly any etching effect on the polyimide resin. Therefore, the second solder resist **3** on the lower side remained as before, without being etched. As a result, openings of the configuration shown in **15** were formed. These were formed so that the area ratio of the first and second openings, $S_2/S_1$, was $S_2/S_1 > 1$, preferably $S_2/S_1 > 2$.

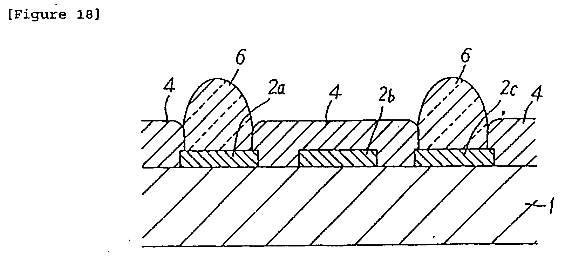

Next, as shown in Figure 16, the openings were filled with solder **6**. In this instance, the second openings had a larger opening area, so even though the opening area of the first openings was small, a large amount of solder could be fed into those openings.

After that, reflow treatment was carried out. By this reflow treatment, the embedded solder was liquified and reliably connected with the conductor lines that lay below it. On liquifying, the solder in the second openings on the upper side collected at the center, as shown in Figure 17, and bumps of sufficient height and sufficient amount of solder were formed. Moreover, even if the second openings overlap adjacent conductor lines, the solder bumps ultimately formed will be of about same diameter as the first openings and will be reliably separated by the second solder resist, so they will not short with adjacent conductor lines.

Next, by immersing the board on which solder bumps had been formed in 2% aqueous sodium hydroxide solution to remove the dry film **5**, the solder bumps shown in Figure 18 could be obtained. With solder bumps formed in this way, the individual conductor lines are completely insulated from each other by polyimide resin, so problems such as shorting do not arise. Also, bumps of sufficient height and sufficient amount of solder are formed, so even if further miniaturized, highly reliable bumps of excellent durability can be formed.

This invention is not limited just to the examples discussed above; various modifications are possible. For example, in the above examples, two openings of different opening area were formed and both openings were round. However, the lower openings that contact the conductor lines may be rectangular and the upper openings round, or both the lower and upper openings can be rectangles of different area. Also, the lower openings can be round and the upper openings rectangular.

Various combinations of solder resist materials can be used. For example, a photosensitive solder resist can be coated so as to fill the spaces between conductor lines, and after that has dried, the same photosensitive solder resist material can be formed as the first resist layer and a dry film laminated over that. A combination of liquid photosensitive polyimide, liquid photosensitive polyimide, and dry film can also be used. Moreover, photosensitive polyimide can be coated, a photosensitive photoresist layer formed over that, and a dry film laminated on that.

[Effects of the invention]

As explained above, according to this invention a first solder resist is formed on a board on which conductor wiring has been formed, openings for forming bumps are formed, a second solder resist is formed on top of the first one, openings are again formed, solder is supplied, reflow treatment is carried out, and then the second solder resist is removed. Therefore, even if the conductor wiring is miniaturized, solder bumps of the desired amount of solder can be formed, and the contamination can also be removed. As a result, solder bumps of excellent reliability even if miniaturized can be formed.

[Brief Description of the Figures]

[Figure 1] A diagrammatic cross section for explaining a process of the method of forming solder bumps of this invention.

[Figure 2] A diagrammatic cross section for explaining a process of the method of forming solder bumps of this invention.

[Figure 3] A diagrammatic cross section for explaining a process of the method of forming solder bumps of this invention.

[Figure 4] A diagrammatic cross section for explaining a process of the method of forming solder bumps of this invention.

[Figure 5] A diagrammatic cross section for explaining a process of the method of forming solder bumps of this invention.

[Figure 6] A diagrammatic cross section for explaining a process of the method of forming solder bumps of this invention.

[Figure 7] A diagrammatic cross section for explaining a process of the method of forming solder bumps of this invention.

[Figure 8] A diagrammatic cross section for explaining a process of the method of forming solder bumps of this invention.

[Figure 9] A diagrammatic cross section for explaining a modification of the method of forming solder bumps of this invention.

[Figure 10] A diagrammatic cross section for explaining another modification of the method of forming solder bumps of this invention.

[Figure 11] A diagrammatic cross section for explaining a process of the other modification of the method of forming solder bumps of this invention.

[Figure 12] A diagrammatic cross section for explaining a process of the other modification of the method of forming solder bumps of this invention.

[Figure 13] A diagrammatic cross section for explaining a process of the other modification of the method of forming solder bumps of this invention.

[Figure 14] A diagrammatic cross section for explaining a process of the other modification of the method of forming solder bumps of this invention.

[Figure 15] A diagrammatic cross section for explaining a process of the other modification of the method of forming solder bumps of this invention.

[Figure 16] A diagrammatic cross section for explaining a process of the other modification of the method of forming solder bumps of this invention.

[Figure 17] A diagrammatic cross section for explaining a process of the other modification of the method of forming solder bumps of this invention.

[Figure 18] A diagrammatic cross section for explaining a process of the other modification of the method of forming solder bumps of this invention.

Explanation of symbols

1: Board
2: Conductor line
3: First solder resist
4: Second solder resist
5: Solder
10: Third solder resist

## Claims

1. A method of forming solder bumps on a board for mounting IC chips on which conductor wiring has been formed, which method is characterized by
   forming a photosensitive first solder resist on the surface of the board on which the conductor wiring has been formed,
   forming first openings by photoetching in the sites of the first solder resist where the solder bumps are to be placed,
   next forming a second solder resist on the first solder resist,
   forming second openings that connect with the first openings by photoetching at sites of the second solder resist that correspond to the first openings,
   filling the first and second openings with solder,
   carrying out reflow treatment,
   and then etching in such a way that at least part of the first solder resist remains.

2. A method of forming solder bumps on IC chip mounting boards on which conductor wiring has been formed, which method is characterized by
   coating a liquid first solder resist on the surface of the board on which the conductor wiring has been formed so that it fills the spaces between the conductor lines,
   forming a second solder resist on the first solder resist,
   forming openings by photoetching at the sites of the first and second solder resists where the solder bumps are to be formed,
   filling the openings with solder,
   carrying out reflow treatment,
   and then etching in such a way that at least part of the first solder resist remains.

3. The method of forming solder bumps of Claim 1 or 2 characterized by constructing the second solder resist from a film-like photosensitive solder resist.

4. The method of forming solder bumps of Claim 1 or 3 characterized by the fact that $S_2/S_1 \geq 1$, where $S_1$ is the opening area of the first openings and $S_2$ is the opening area of the second openings.

5. The method of forming solder bumps of any of Claims 1 to 4 characterized by making the first solder resist from a material of slower etching rate than the material of the second solder resist with respect to a specific etchant.

6. A method of forming solder bumps on IC chip mounting boards on which conductor wiring has been formed, which method is characterized by
   coating a liquid first solder resist on the surface of the board on which the conductor wiring has been formed so that it fills the spaces between conductor wires,
   forming a photosensitive second solder resist on the first solder resist,
   forming first openings at the sites of the second solder resist where the solder bumps are to be formed,
   forming a third solder resist on the second solder resist,
   forming second openings that connect with the first openings by photoetching at sites of the third solder resist that correspond to the first openings,
   filling the first and second openings with solder,
   carrying out reflow treatment,
   and then removing the third solder resist.

7. The method of forming solder bumps of Claim 6 which is characterized by establishing that $S_2/S_1 \geq 1$, where $S_1$ is the opening area of the first openings and $S_2$ is the opening area of the second openings.

8. The method of forming solder bumps of Claim 7 characterized by forming the said openings in a zigzag pattern.

[Figure 1]

[Figure 2]

[Figure 3]

[Figure 4]

[Figure 5]

[Figure 6]

[Figure 7]

[Figure 8]

[Figure 9]

(a)

(b)

(c)

[Figure 10]

[Figure 11]

[Figure 12]

[Figure 13]

[Figure 14]

[Figure 15]

[Figure 16]

[Figure 17]

[Figure 18]